# EUROPEAN PATENT APPLICATION

(11) **EP 4 637 285 A1**
(43) Date of publication of application: **22.10.2025**
(21) Application number: 25165538.7
(22) Date of filing: 24.03.2025
(51) Int. Cl.: H05K 7/20

(54) **SHELL COMPONENTS AND INVERTERS**

(30) Priority: 18.04.2024 CN 202410472147
(71) Applicant: MAHLE International GmbH, 70376 Stuttgart (DE); MAHLE Automotive Technologies (China) Co., Ltd., Shanghai 201401 (CN)
(72) Inventor: HOU, Kangkai, Shanghai, 201401 (CN); LI, Yupeng, Shanghai, 201401 (CN)
(74) Representative: BRP Renaud & Partner mbB Rechtsanwälte Patentanwälte Steuerberater

(57) **Abstract**

This application discloses a shell component and an inverter, belonging to the technical field of motor inverters. The provided shell component includes a shell and a water jacket, wherein the interior of the shell has an accommodating space, and at least a portion of the water jacket is provided within the accommodating space; The water jacket comprises a water jacket body and a cooling plate. The water jacket body is made of plastic material, and a cooling channel is formed inside the cooling plate. The water jacket body is equipped with a first cooling circuit for cooling the power module and a second cooling circuit for cooling the excitation module. The first cooling circuit and the second cooling circuit are respectively connected to the cooling channel. An inverter comprising a housing component. This application can at least solve the problem of heavy weight and complex structure of the shell components of traditional inverters.

## Description

### Technical field

This application belongs to the field of motor inverter technology and specifically relates to a shell component and an inverter.

### Background technology

In recent years, with the gradual warming of the global climate, reducing carbon emissions remains the most urgent task today. At present, the market share of electric vehicles such as pure electric vehicles or hybrid vehicles is rapidly increasing, and major domestic and foreign related enterprises still need to face energy conservation and emission reduction. At the same time, in order to achieve higher range, the motor traction inverter of electric vehicles also requires smaller size and lighter weight.

The shell of traditional inverters is usually made of cast aluminum, and its main component is the water jacket. The main body of the inverter shell is mostly made of cast aluminum material. The power module and capacitor parts of the inverter shell are usually integrated with the box shaped cast aluminum water jacket, and the cooling water circuit of the water jacket is sealed on the flat cast aluminum shell. However, the aluminum water jacket has certain shortcomings. For example, the overall material of the shell and water jacket is mostly cast aluminum, which adds a lot of weight to the motor inverter; In addition, the existing water jacket has a complex cooling water path, which requires more design space and increases the overall size of the shell and water jacket. In addition, the existing cast aluminum material water jacket has high pollution and energy consumption in the production process. In the later processing, the metal cutting process is complex and inconvenient for processing and production. Therefore, how to further reduce the weight of the inverter housing components to achieve the goal of further reducing motor load is still the current direction of exploration.

### Technical effects

In the present embodiment, the provided shell component includes a shell and a water jacket, wherein the water jacket body of the water jacket is made of plastic material. Compared with the existing aluminum water jacket, the weight of the shell component can be effectively reduced, thereby helping to reduce the weight of the motor inverter. At the same time, the water jacket body made of plastic material is used, and the cooling water path set in the water jacket does not need to occupy too much space, which can reduce the volume of the shell components. Oil inlet helps to reduce the overall space occupied by the inverter. Moreover, the internal orientation and structure of the plastic water jacket body can be directly integrated by injection molding, thereby reducing the number of parts and some sealing parts, such as power modules, capacitors, and busbars, which can be directly integrated into the plastic water jacket body without the need for additional connectors, reducing the number of parts and lowering costs.

### Description Drawings

Figure 1 is a schematic diagram of the structure of the shell components provided in some exemplary embodiments of the present application;
Figure 2 is a schematic diagram of the structure of the water jacket provided in some exemplary embodiments of the present application;
Figure 3 is a schematic diagram of the first perspective structure of a water jacket provided in some exemplary embodiments of the present application;
Figure 4 is a schematic diagram of the structure of a second perspective water jacket provided by some exemplary embodiments of the present application;
Figure 5 is a schematic diagram of the connection of temperature sensors provided in some exemplary embodiments of the present application;
Figure 6 is a schematic diagram of the weight comparison between the water jacket provided in the present embodiment and the water jacket in the prior art.

Description of the pictorial markers:
10- Shell;
20- Water jacket;
21- Water jacket body; 211- First cooling circuit; 2111- First sealing groove; 212- Second cooling circuit; 2121- Second sealing groove;
22- Cooling plate; 221- Liquid inlet; 222- Liquid outlet;
23- First sealing element; 24- Second sealing element;
25- Cooling nut; 26- Grounding nut; 27- Temperature sensor; 271- Joint; 28-Busbar; 29-PN terminal;
30- Shield board.

### Embodiment

In some embodiments of this application, a housing component is provided, which can be applied in the field of motors, such as in motor inverters, for achieving the functions of housing protection and cooling. In addition, it can also be used in other devices. The present embodiment does not impose specific limitations on the specific usage scenarios and working conditions of the shell components.

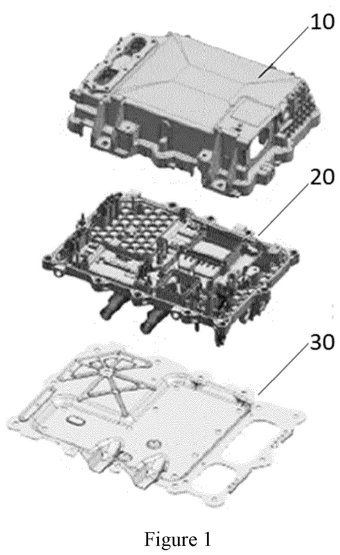

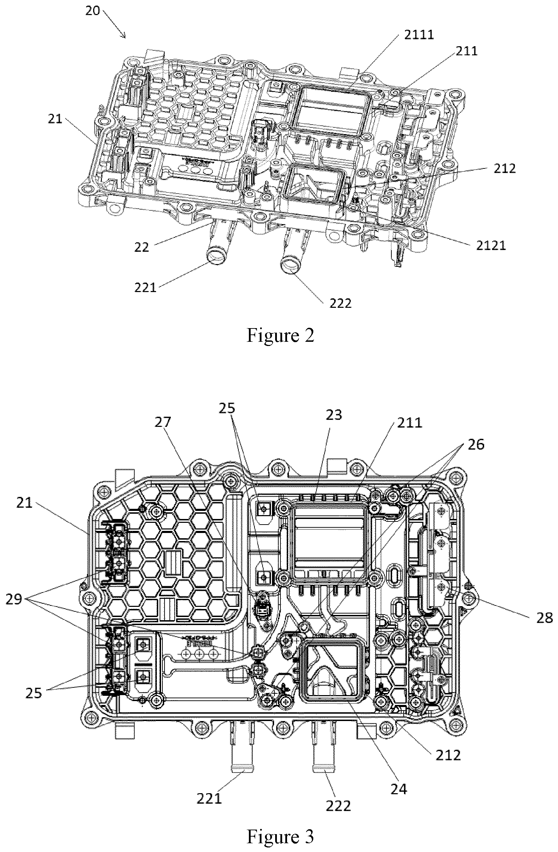

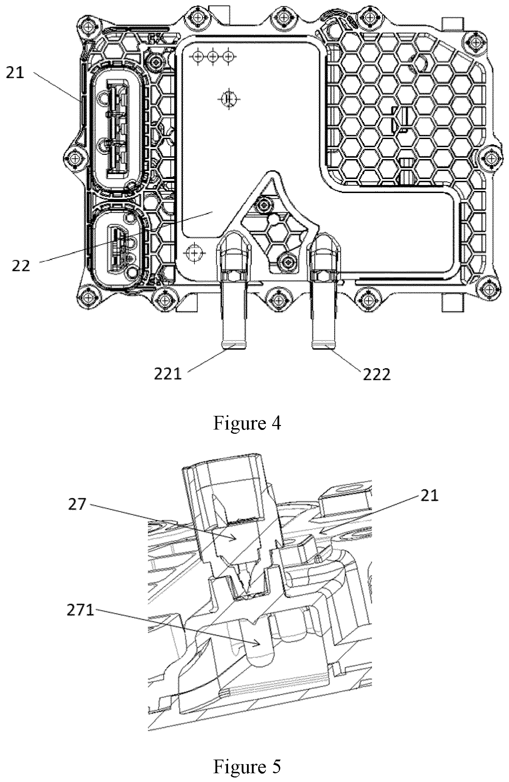

Please refer to Figures 1 to 6. In some embodiments, there is provided a housing component comprising a housing 10 and a water jacket 20; The outer shell 10 can provide protection and other functions, and the interior of the outer shell 10 can form a space for accommodations; At least a portion of the water jacket 20 can be provided in the accommodating space of the outer shell 10, for example, the water jacket 20 can be located as a whole within the accommodating space, or a portion of the water jacket 20 can be located within the accommodating space, and a small portion of the water jacket 20 can also be protruded outside the accommodating space.

As an example, the above-mentioned shell 10 can adopt a box shape with an opening, for example, the shell 10 can adopt an open end structure, and the bottom wall (or top wall) of the shell 10 is surrounded by the surrounding side walls to form a structure with internal accommodating space, which can be used to accommodate components such as the water jacket 20. By placing the water jacket 20 in the accommodating space of the housing 10, the box shaped housing 10 can protect the water jacket 20 and its components from external collision and impact, providing safety protection.

Optionally, the material of shell 10 can be metal. For example, the outer shell 10 can be made of cast aluminum material. Of course, in other embodiments, the outer shell 10 may also use other materials, and this embodiment is not limited to this. By using a cast aluminum shell 10, compared to other metal materials, it is lightweight, has good thermal conductivity, and reliable structural strength.

In this embodiment, the water jacket 20 comprises a water jacket body 21 and a cooling plate 22, which can be connected to one side of the surface of the water jacket body 21. As an example, the water jacket body 21 may include opposite first and second surfaces (upper and lower surfaces), and the cooling plate 22 may be connected to either the first or second surface of the water jacket body 21. For example, multiple components can be integrated on the first surface of the water jacket body 21, and the cooling plate 22 can be connected to the second surface of the water jacket body 21.

In this embodiment, the water jacket body 21 is made of plastic material, and the water jacket 20 in this embodiment can also be referred to as a plastic water jacket; The water jacket body 21 can be equipped with multiple cooling circuits for cooling different modules. For example, in this embodiment, the water jacket body 21 is equipped with at least a first cooling circuit 211 and a second cooling circuit 212. A cooling channel is formed inside the cooling plate 22, and a cooling medium such as coolant can be introduced into the cooling channel. The first cooling circuit 211 and the second cooling circuit 212 are respectively connected to the cooling channel, so that the cooling liquid in the cooling channel can flow through the first cooling circuit 211 and the second cooling circuit 212, respectively.

Among them, the first cooling circuit 211 can be used to cool the power module. For example, by making the power module come into contact with the side wall of the first cooling circuit 211, the cooling medium inside the first cooling circuit 211 can pass through the power module and cool the power module. The second cooling circuit 212 can be set at intervals with the first cooling circuit 211, and the second cooling circuit 212 can be used to cool the excitation module. For example, by making the excitation module come into contact with the side wall of the second cooling circuit 212, the cooling medium inside the second cooling circuit 212 can pass through the excitation module and cool the excitation module.

Compared to the conventional water jacket in existing technology, the water jacket 20 in this embodiment adds a second cooling circuit 212 for cooling the excitation module. Through the setting of the second cooling circuit 212, it can match the wound magnetic pole synchronous motor used in the new motor. That is to say, adding new semiconductor modules such as excitation module interfaces on the water jacket 20 can meet the needs of relevant customers to match new modules. Therefore, by adding a second cooling water circuit for cooling the excitation module, it can meet the needs of different customers, with strong practicality and wide application range.

Therefore, based on the above settings, using the shell components provided in this embodiment, an integrated plastic water jacket 20 is proposed compared to the existing metal aluminum water jacket, which can effectively reduce the weight of the shell components and help to reduce the weight of the motor inverter. At the same time, the water jacket body 21 made of plastic material and the cooling water circuit set in the water jacket 20 do not need to occupy too much space, which can reduce the volume of the shell components. The oil inlet helps to reduce the overall space occupied by the inverter. Moreover, the internal orientation and structure of the plastic water jacket body 21 can be directly integrated by injection molding, which can reduce the number of parts and some sealing parts, such as power modules, capacitors, and busbars 28, which can be directly integrated into the plastic water jacket body 21 without the need for additional connectors. This reduces the number of parts while also reducing costs, simplifying the structure, avoiding the defects of complex water circuit structures, requiring excessive space occupation, and increasing the size of shell components, as well as avoiding the defects of the existing aluminum water jacket requiring connectors to connect power modules, capacitors, busbars 28, and other parts, resulting in a large number of parts and lower costs.

The shell component of this embodiment can be made of metal material, such as using the original cast aluminum material. The water jacket body 21 is made of plastic material, and the combination of metal and plastic is used. Compared to the original metal water jacket, this method ensures that the shell 10 protects the motor inverter and provides good heat dissipation, greatly reducing the weight of the shell component. The plastic water jacket body 21 has a simpler, more efficient, and lower cost production process compared to metal, and has less carbon emissions and pollution during the production process. Due to the weight reduction of the shell components, the overall weight of the motor inverter installed with this shell component can be reduced, further reducing the weight of the carrier powered by this type of motor, thereby helping to reduce overall energy consumption and improve the endurance of the carrier. It can be widely used in various fields with high weight requirements.

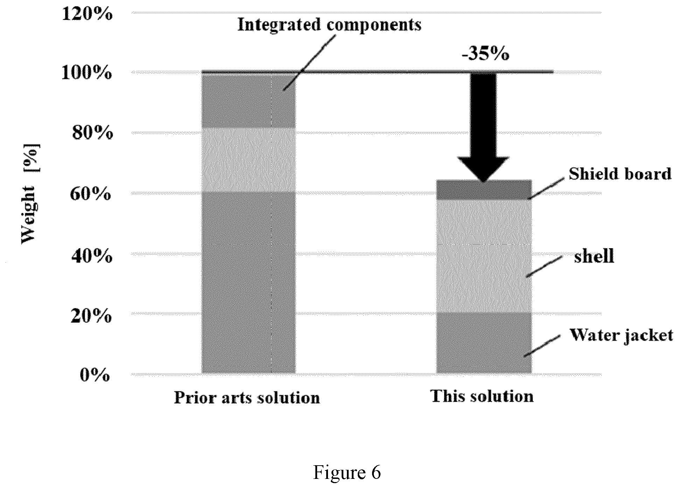

After experimental verification, as shown in Figure 6, due to the use of plastic water jacket 20 in the embodiment of the present invention, compared to the traditional aluminum shell component, the weight of the inverter shell component in this embodiment can be reduced by about 35% compared to the traditional aluminum material.

In some embodiments, the housing component further includes a shielding plate 30, which is connected to one side of the water jacket 20 with a cooling plate 22. As an example, cooling plate 22 is connected to the bottom surface of water jacket body 21, and shielding plate 30 is connected to one side of the bottom surface of water jacket body 21. By setting the shielding plate 30, the impact of electromagnetic waves can be shielded to ensure the EMC performance of the inverter.

In this embodiment, a plastic water jacket 20 with a similar flat shape is used instead of the existing aluminum water jacket structure. The plastic water jacket 20, the metal shielding plate 30, and the metal shell 10 can together form a new type of motor inverter box, also known as the shell component. The metal shell 10 in the shape of the box can protect the plastic water jacket 20 and its components from external collision and impact; In addition, in order to shield the impact of electromagnetic waves and ensure the EMC performance of the inverter, a metal shielding plate 30 is installed at the bottom of the plastic water jacket 20.

It should be noted that this embodiment does not limit the specific shape and structure of the shell 10 and the shielding plate 30. The structure of the shell 10 and the shielding plate 30 shown in Figure 1 is only exemplary, and their specific shape, structure, or connection method can be referred to relevant existing technologies, and will not be described in detail here.

The material of the water jacket body 21 made of plastic material mentioned above can be plastic resin. By using plastic resin material, the size and weight of the overall assembly can be reduced, and the characteristics of plastic can be maximized to meet the necessary functions of the product.

In some embodiments, plastic materials include but are not limited to high-temperature resistant thermoplastic plastics, which include but are not limited to any one or two or more mixtures of PPS (polyphenylene sulfide) resin, PPA (poly phthalamide) resin, PES (polyethersulfone) resin, PEEK (polyether ether ketone) resin, or PEI (polyether imide) resin.

In the above technical solutions, several thermoplastic materials are used, which have the characteristics of high strength and light weight, and have certain properties of high temperature and high humidity resistance, which can meet the application requirements in motor inverters.

In addition, in other embodiments, the specific types of plastic materials mentioned above are not limited to the ones listed above. While meeting the requirements of certain strength, light weight, and high temperature resistance that can be applied in motor inverters, other types of plastic materials can also be used, and will not be described in detail here.

Preferably, in this embodiment, the water jacket body 21 is made of PPS (polyphenylene sulfide) resin. The water jacket body 21 can meet the required functions of the product by selecting high toughness grade plastic resin PPS. For example, the PPS material has the characteristics of high temperature and high humidity resistance, sufficient insulation for high voltage, high strength, and sufficient strength to meet the required requirements. Due to the use of the plastic material water jacket 20, the weight of the inverter housing component can be reduced by about 35% compared to traditional aluminum housing components, greatly reducing the weight of the inverter.

In some embodiments, the cooling plate 22 is made of plastic or metal material. The material of the cooling plate 22 mentioned above can be plastic, for example, the material of the cooling plate 22 can be the same as the material of the water jacket body 21 mentioned above; This helps to further reduce the weight of the shell component, thereby reducing the overall weight of the motor inverter installed with the shell component. Alternatively, the material of cooling plate 22 can also be made of metal, such as aluminum.

In some embodiments, the water jacket body 21 and the cooling plate 22 are connected by welding.

In this embodiment, the water jacket body 21 and the cooling plate 22 can be welded together through vibration friction, so that the connection structure is firm and reliable, which helps to ensure the tightness of the connection between the water jacket body 21 and the cooling plate 22, ensure the sealing of the coolant, reduce the risk of coolant leakage, and improve the overall stability and reliability of the structure.

Alternatively, in other embodiments, the water jacket body 21 and the cooling plate 22 can also be integrally formed, that is, while forming the water jacket body 21, the cooling plate 22 can also be formed together. For example, when both the water jacket body 21 and the cooling plate 22 are made of plastic material, the water jacket body 21 and the cooling plate 22 can be integrated by injection molding.

Furthermore, in order to improve the sealing of the cooling circuit, multiple sealing elements are also provided in this embodiment to further ensure the sealing of the coolant. As an example, in some embodiments, the housing assembly further comprises a first seal 23 and a second seal 24; One end of the first cooling circuit 211 is formed with a first sealing groove 2111, and the first sealing element 23 is assembled inside the first sealing groove 2111; One end of the second cooling circuit 212 is formed with a second sealing groove 2121, and the second sealing element 24 is assembled inside the second sealing groove 2121.

Optionally, both the first seal 23 and the second seal 24 mentioned above are sealing rings, such as square ring seals. The first sealing groove 2111 and the second sealing groove 2121 mentioned above are both annular sealing grooves, such as square annular sealing grooves.

By opening a first sealing groove 2111 at the upper end of the first cooling circuit 211 and a second sealing groove 2121 at the upper end of the second cooling circuit 212, and pressing the first sealing ring into the first sealing groove 2111, and pressing the second sealing ring into the second sealing groove 2121, the sealing performance of the first cooling circuit 211 and the second cooling circuit 212 can be improved, and the risk of coolant leakage can be reduced or avoided.

In some embodiments, the cooling plate 22 is equipped with an inlet 221, and the cooling medium such as coolant flows into the cooling channel through the inlet 221; The cooling plate 22 is also equipped with an outlet 222, and the cooling medium flows out of the cooling channel through the outlet 222. The inlet 221 and outlet 222 of the cooling plate 22 can be respectively convex on the outer side of the water jacket body 21 to facilitate connection with the cooling medium source.

The above cooling plate 22 is equipped with an inlet port 221 and an outlet port 222. The inlet port 221 can be connected to the head end of the cooling channel, and the outlet port 222 can be connected to the tail end of the cooling channel. After the cooling medium, such as coolant, enters the cooling channel from the inlet 221, it can flow along the distribution trajectories of the first cooling circuit 211 and the second cooling circuit 212, respectively. During this process, it receives heat from various components such as the power module, excitation module, or inverter body, and the temperature rises. Finally, it flows out from the outlet 222.

In some embodiments, the water jacket body 21 is equipped with at least one integrally formed cooling nut 25, which is made of metal material.

In this embodiment, multiple cooling nuts 25 can be installed on the water jacket body 21. As an example, the cooling nut 25 can be a bus cooling nut 25, and the number of bus cooling nuts 25 can be 4. The 4 bus cooling nuts 25 are spaced on the water jacket body 21, and the bus cooling nuts 25 can be connected to the cooling channel. Of course, in other embodiments, the number of bus cooling nuts 25 can also be 2, 3, or greater than 4, etc. This embodiment is not limited to this.

The above-mentioned cooling nut 25 can be made of metal material, and can be integrally formed with the water jacket body 21. For example, the cooling nut 25 can be integrally formed with the water jacket body 21 through injection molding, which has a simple structure, reliable connection, simpler production process, higher efficiency, and helps to reduce production costs.

Optionally, there are multiple components on the water jacket body 21, which are connected to the water jacket body 21 through cold pressing.

According to this embodiment, the water jacket body 21 is equipped with a first cooling circuit 211, a second cooling circuit 212, a first sealing ring, a second sealing ring, and multiple cooling nuts 25, such as a bus cooling nut 25 made of multiple metal materials. In addition, various components (such as other metal parts) can also be provided. These components, such as metal parts bushings, grounding nuts 26, integrated bus 28 terminals, and temperature sensors 27, can be assembled to the water jacket body 21 through cold pressing or other methods.

This embodiment utilizes the characteristics of plastic to form a flexible cooling water path (cooling circuit) and reduce the number of components by using a water jacket body 21 made of plastic material. Compared to traditional aluminum water jackets, other pressure type pipe (other parts) joints and seals need to be installed at the inlet and outlet of the waterway, and the complex internal waterway can only be achieved through aluminum casting and processing. The internal direction and structure of the plastic water jacket 20 in this embodiment can be directly integrated by injection molding, thereby reducing the number of parts and some sealing parts; At the same time, the plastic water jacket structure of this embodiment can flexibly design cooling water circuits, such as cooling the excitation module and bus cooling nut 25, with good flexibility and strong adaptability.

In some embodiments, the components include multiple grounding nuts 26, which are spaced on the water jacket body 21. As an example, the number of grounding nuts 26 can be 3, and 3 grounding nuts 26 are spaced on the water jacket body 21. Of course, in other embodiments, the number of grounding nuts 26 can also be other quantities, and this embodiment is not limited to this.

In this embodiment, unique designs have been made for the cooling nut 25, such as the busbar cooling nut 25 and the grounding nut 26. For example, the cooling nut 25 is made of a metal material such as aluminum and is designed separately to reduce temperature. Heat is transmitted to the fixing bolts through the power module, DC AC capacitor, and busbar board, and comes into contact with the cooling nut 25. It is then radiated to the coolant through the water jacket, achieving cooling. In addition, to prevent potential leakage of high voltage current, the lower surface of the nut can be wrapped in plastic.

In some embodiments, the components include a temperature sensor 27, and the connector 271 of the temperature sensor 27 is inserted into the water jacket body 21.

In this embodiment, a temperature sensor 27 is integrated and installed on the water jacket 20. Due to the use of plastic material for the water jacket body 21, the joint 271 shell of the temperature sensor 27 can be better integrated on the water jacket body 21, and the sensor can be directly inserted into the joint. As a result, compared to traditional water jacket sensor structures, it eliminates the need for sealing components and potential leakage risks.

Optionally, the components include busbar 28/terminal, which is connected to the power module. For example, busbar 28 can be coupled to the outer side of the power module for connecting external motors and power modules to each other.

Furthermore, in this embodiment, high-voltage components are integrated. Due to the good insulation and fluidity of the plastic itself, high-voltage components such as busbar copper bars can be more easily integrated together, while also saving a lot of space for the assembly.

Optional, components include AC capacitors.

Optionally, the components include PN terminal 29, which refers to the capacitor wiring terminal.

It should be pointed out that the components integrated on the water jacket body 21 include but are not limited to the aforementioned components. In addition to the aforementioned components, various components suitable for traditional water jacket bodies can also be included, which will not be repeated here.

In some embodiments, an inverter is provided, comprising an inverter body and the aforementioned housing components.

It should be noted that inverter equipment is usually composed of power modules, DC bus capacitors, main control and drive circuit boards, sensors, EMC filters, and necessary mechanical components. This embodiment does not limit the specific structural form of the inverter body, namely the drive circuit board, power module, etc. It can refer to relevant existing technologies and will not be described in detail here.

In the above-mentioned inverters, the water jacket 20 in the shell component adopts a partially liquid cooled structure, which can mainly use the cooling liquid in the cooling circuit to cool and dissipate heat for the power modules, DC bus capacitors, excitation modules, etc. with high heat generation in the inverter.

## Claims

1. A shell component, **characterized in that** it comprises:
An outer shell, wherein the interior of the outer shell has a accommodating space;
A water jacket, wherein at least a portion of the water jacket is provided in the accommodating space;
The water jacket comprises a water jacket body and a cooling plate. The water jacket body is made of plastic material, and a cooling channel is formed inside the cooling plate. The water jacket body is equipped with a first cooling circuit for cooling the power module and a second cooling circuit for cooling the excitation module. The first cooling circuit and the second cooling circuit are respectively connected to the cooling channel.

2. The shell component according to claim 1, **characterized in that** the plastic material comprises a high-temperature resistant thermoplastic, wherein the high-temperature resistant thermoplastic comprises at least one of PPS resin, PPA resin, PES resin, PEEK resin, or PEI resin;
And/or, the cooling plate is made of plastic or metal material.

3. The shell component according to claim 1, **characterized in that** the water jacket body and the cooling plate are welded and connected;
Alternatively, the water jacket body and the cooling plate can be integrally formed.

4. The shell component according to claim 1, **characterized in that** the shell component further comprises a first seal and a second seal;
One end of the first cooling circuit is formed with a first sealing groove, and the first sealing element is assembled inside the first sealing groove;
One end of the second cooling circuit is formed with a second sealing groove, and the second sealing element is assembled inside the second sealing groove.

5. The shell component according to claim 1, **characterized in that** the cooling plate is equipped with an inlet, and the cooling medium flows into the cooling channel through the inlet;
The cooling plate also has an outlet, and the cooling medium flows out from the cooling channel through the outlet.

6. The shell component according to any one of claims 1 to 5, **characterized in that** at least one integrally formed cooling nut is provided on the water jacket body, and the cooling nut is made of metal material;
And/or, the water jacket body is equipped with multiple components, which are connected to the water jacket body through cold pressing.

7. The shell component according to claim 6, **characterized in that** the component comprises a temperature sensor, and the connector of the temperature sensor is inserted into the water jacket body.

8. The shell component according to claim 6, **characterized in that** the component comprises multiple grounding nuts, which are spaced on the water jacket body;
And/or, the components include a busbar, which is connected to the power module;
And/or, the components include AC capacitors.

9. The shell component according to any one of claims 1 to 5, **characterized in that** the shell component further comprises a shielding plate, which is connected to one side of the water jacket with the cooling plate.

10. An inverter, **characterized in that** it comprises an inverter body and a housing component as claimed in any one of claims 1 to 9.
